# FASCICULE DE BREVET EUROPEEN

(11) **EP 0 755 178 B1**
(45) Date de publication et mention de la délivrance du brevet: **23.06.1999**
(21) Numéro de dépôt: 96401570.5
(22) Date de dépôt: 16.07.1996
(51) Int. Cl.: H05K 9/00, H04M 1/02

(54) **Appareil de communication avec protection électrostatique**
Kommunikationsgerät mit elektrostatischem Schutz
Communication device with an electrostatic protection

(30) Priorité: 18.07.1995 FR 9508670
(43) Date de publication de la demande: 22.01.1997
(73) Titulaire: ALCATEL, 75008 Paris (FR)
(72) Inventeur: Villain, Jean-Christophe, 75018 Paris (FR); Bezieres, Alain, 53150 St Cenere (FR)
(74) Mandataire: Pothet, Jean Rémy Emile Ludovic

(56) Documents cités:
- EP-A- 0 467 726
- DE-A- 4 041 071
- GB-A- 1 088 408
- US-A- 4 471 493
- US-A- 5 005 106
- US-A- 5 383 097
- US-A- 5 418 693
- IBM TECHNICAL DISCLOSURE BULLETIN , vol. 30, no. 1, Juin 1987, NEW YORK, pages 237-238, XP000577393 "SHIELD ARRANGEMENTS"
- IBM TECHNICAL DISCLOSURE BULLETIN, vol. 28, no. 10, Mars 1986, NEW YORK, pages 4342-4343, XP002017587 "COPPER/POLYESTER LAMINATE AS AN EMI/ESD SHIELD "

## Description

L'invention concerne un appareil de communication doté d'une protection électrostatique comprenant un corps plat en matériau isolant.

Par le document de brevet GB-2 241 628, on connaît un récepteur acoustique qui est doté d'une plaque de protection électrostatique. Par le document de brevet US-5,053,167 on connaît un article en caoutchouc utilisable entre autres comme protection électrostatique.

Dans le premier document, la protection électrostatique est abordée sous l'angle de la prévention des décharges électrostatiques par l'augmentation des distances de décharge. La source de telles décharges est en effet extérieure à l'appareil ; c'est l'utilisateur de l'appareil et il faut éviter que de telles décharges n'atteignent des dispositifs électroniques fragiles à l'intérieur de l'appareil.

Dans le second document, la protection électrostatique est mentionnée seulement. On comprend toutefois que l'on cherche à empêcher l'accumulation de charges électrostatiques par mise à la masse de celles-ci.

Dans les deux cas, il est question de protection aux décharges électrostatiques seulement. D'autres aspects de protection ne sont pas traités. Dans les deux cas encore, la protection est basée sur l'emploi de pièces spécifiques, donc relativement coûteuses.

La présente invention concerne un appareil de communication du type envisagé au début de ce document, dans lequel la protection électrostatique concerne la protection aux décharges électrostatiques, mais est également apte à d'autres fonctions de protection et est obtenue par des moyens peu onéreux.

On connaît certes, par le document US - 5,383,097, un appareil doté d'une protection électrostatique comprenant un corps plat en matériau isolant consistant en une feuille protectrice incorporée dans l'appareil, entre la coque et les éléments à protéger, cette feuille protectrice comprenant une couche conductrice et une couche isolante et étant découpée à la forme appropriée. Toutefois, la feuille protectrice employée est relativement rigide (Mylar) et aucun autre emploi n'en est prévu que celui de protection électrostatique.

On connaît également du document GB 1, 088, 408 un écran de protection pour des composants électriques montés sur des circuits imprimés, constitué d'une couche en matériau thermoplastique recouverte d'un film conducteur, recouverte à son tour d'un revêtement isolant. Lorsque l'écran de protection est en place, il n'y a cependant aucun contact direct entre les composants électriques et l'écran de protection. En outre, il est nécessaire de conformer la couche en matériau thermoplastique en une forme rigide, avant mise en place de l'écran de protection de manière à ce que cet écran suive les contours des composants électriques à protéger.

La présente invention a pour but de proposer un appareil de communication muni d'une protection électrostatique dont la fabrication et la mise en place dans l'appareil soit simple et peu coûteuse. Cette protection électrostatique assurant également la fonction d'étanchéité aux sons et à la poussière.

Ce but est atteint grâce à un appareil de communication tel que défini dans la revendication 1.

Dans une forme de réalisation, ladite couche conductrice est une feuille mince de métal ou de fibres métalliques revêtue d'une couche adhésive.

Dans une forme de réalisation, ladite couche conductrice est pourvue de moyens de connexion à la masse. Ces moyens consistent de préférence en une patte de ladite feuille et l'appareil comprend un poussoir pour presser cette patte contre une zone de contact de masse.

Dans une forme de réalisation également, ladite couche isolante est une feuille de mousse de polyuréthane.

Il est clair qu'une telle feuille protectrice est peu onéreuse car elle est obtenue par simple découpage dans une feuille d'un matériau bon marché et qu'il est aisé et peu coûteux de la mettre en place dans l'appareil.

De plus, elle joue un rôle additionnel d'étanchéité contre les sons et la poussière.

Les différents objets et caractéristiques de la présente invention apparaîtront plus clairement dans la description qui va suivre d'un mode de mise en oeuvre de l'invention, donnée à titre d'exemple non limitatif, en se reportant aux figures annexées qui représentent :
- la figure 1, une vue en coupe d'une portion de la feuille protectrice employée dans la présente invention,
- la figure 2, une vue en plan d'un appareil de radiotéléphonie dans lequel est appliquée la présente invention,
- la figure 3, une vue en coupe partielle, simplifiée, selon l'axe A-A' de la figure 1, de l'appareil de radiotéléphonie de la figure 2, doté d'une feuille protectrice conforme à la figure 1,
- la figure 4, une vue en plan avant usage d'une feuille protectrice utilisée dans l'appareil des figures 2 et 3, et
- la figure 5, une vue en coupe partielle agrandie par rapport aux figures 2 et 3, de l'appareil de la figure 2, pratiquée selon la ligne B-B' de cette dernière figure.

Dans l'appareil de communication doté d'une protection électrostatique de l'invention, comprenant un corps plat en matériau isolant, la protection électrostatique consiste en une feuille protectrice incorporée dans l'appareil, entre la coque et les éléments à protéger, comprenant une couche conductrice et une couche isolante, cette feuille étant découpée à la forme appropriée et étant faite de matériaux qui la rendent aisément conformable, pour s'adapter, dans l'appareil, à la forme d'un espace laissé libre pour la recevoir.

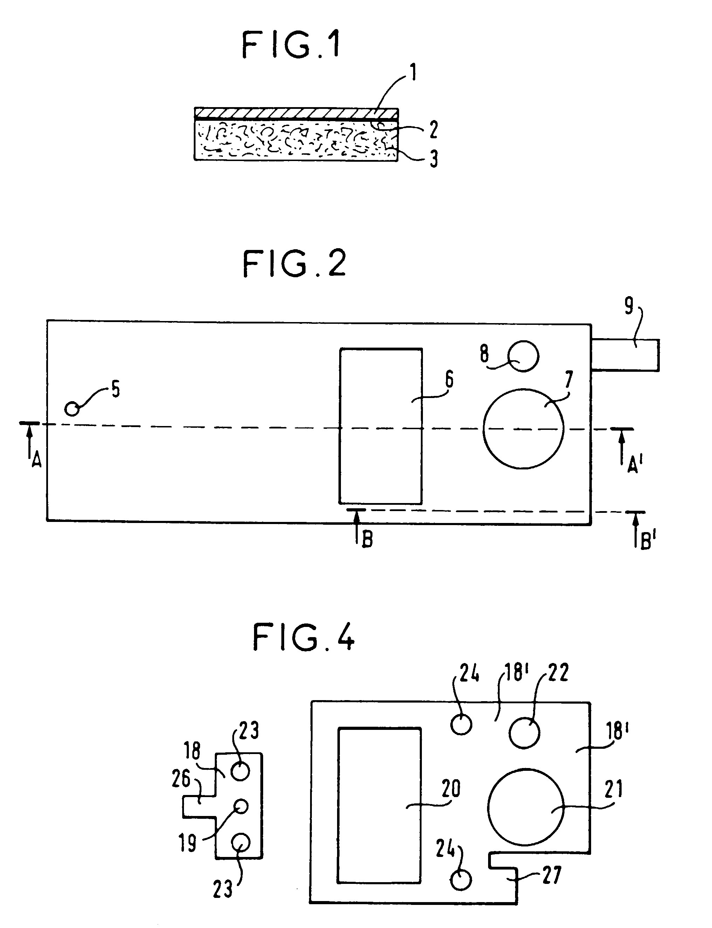

Un exemple d'une telle feuille protectrice est illustré à la figure 1. La feuille protectrice y comprend, conformément à ce qui précède, une couche conductrice 1, une couche d'adhésif 2 et une couche isolante 3. La couche d'adhésif peut avoir été prévue initialement sur la couche conductrice 1, en vue de coller cette dernière sur la couche isolante 3. On peut aussi envisager le cas où, au contraire, la couche adhésive 2, initialement prévue sur la couche isolante 3 servirait à coller cette dernière sur la couche conductrice 1.

Dans une forme de réalisation, la couche conductrice 1 est une feuille mince de métal conducteur, en aluminium par exemple, tandis que la couche isolante 3 est une feuille de mousse de matière plastique, du polyuréthane par exemple. Alternativement la couche conductrice peut être faite de fibres métalliques.

A titre d'exemple d'application de l'invention, la figure 2 représente, vu en plan et très schématiquement, un appareil radiotéléphonique comprenant une coque 4 dans laquelle sont découpés des orifices de microphone 5, d'afficheur 6, d'écouteur 7 et de ronfleur 8. On y voit aussi une antenne 9.

Un tel appareil, porté au contact de la tête de l'utilisateur, qui peut être chargé d'électricité statique, pourrait donner lieu à une décharge qui, outre qu'elle est désagréable pour l'utilisateur, serait susceptible d'endommager des composants fragiles des circuits de l'appareil. Par ailleurs, comme la coque est découpée, des poussières extérieures pourraient s'introduire dans l'appareil. Enfin, à l'intérieur de la coque, le microphone et l'écouteur ou le ronfleur pourraient interférer. Rien de cela n'est évidemment acceptable. L'invention permet d'éviter ces inconvénients de manière simple et peu onéreuse.

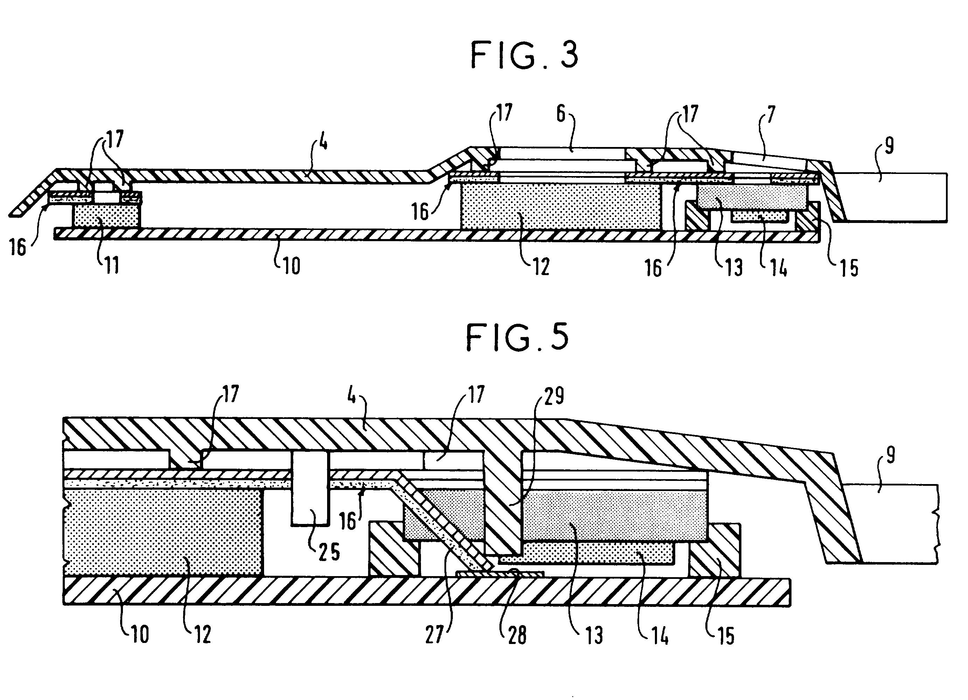

La solution de l'invention est visible sur la vue en coupe partielle de la figure 3, pratiquée selon l'axe A-A' de la figure 2.

On y voit une plaque de circuits imprimés 10, portant un microphone 11, un afficheur de type LCD 12, un écouteur 13, un ronfleur 14, représentés de façon très schématique. Les moyens de fixation de ces composants sur la plaque 10 ne sont pas figurés. On a simplement évoqué une monture 15 pour la mise en position adéquate de l'écouteur 13.

Ces composants sont en position adéquate lorsque la coque 4 est mise en place par rapport à la plaque 10, c'est-à-dire en face des orifices correspondants. Ces composants sont raccordés à des circuits électroniques non représentés, par des connexions également non représentées qui, proches des orifices de la coque, peuvent véhiculer des courants de décharge électrostatique ayant leur origine dans une partie du corps ou des vêtements de l'utilisateur.

Pour protéger ces circuits et l'utilisateur de telles décharges, l'invention prévoit une feuille protectrice 16, incorporée dans l'appareil, entre la coque 4 et les éléments à protéger, c'est-à-dire les composants 11, 12, 13, 14. Cette feuille est conforme à ce que l'on a décrit en se reportant à la figure 1.

La coque 4 comprend en outre avantageusement des nervures d'étanchéité 17, en direction de la surface des composants 11, 12, 13, 14. La feuille 16 peut être réalisée en plusieurs parties chacune de forme adaptée aux composants ou parties de l'appareil à protéger, comme on le verra par la suite. Sa couche conductrice est tournée vers la coque et contre les nervures, tandis que sa couche isolante seulement s'appuie sur les composants.

L'épaisseur de la feuille protectrice, par rapport à l'espace libre entre la coque 4 et les composants portés par la plaque 10 est tel que, compte tenu des nervures 17, la feuille soit comprimée, ce qui réalise une étanchéité à la fois à l'égard des sons et des poussières autour des composants, et isole chaque composants par rapport aux autres dans la coque 4.

La figure 4 illustre la découpe de la feuille 16, telle qu'elle peut être employée dans l'appareil des figures 2 et 3. La feuille comprend alors deux parties, 18 et 18'. La partie 18 est prévue autour du microphone 11, comme indiqué sur la figure 3. La partie 18' correspond à la zone de l'appareil qui comprend l'afficheur 12, l'écouteur 13 et le ronfleur 14, comme indiqué également sur la figure 3. La partie de feuille protectrice 18 comprend un poinçonnage 19 pour permettre le passage des sons en direction du microphone 11. La partie de feuille protectrice 18' comprend de même un poinçonnage 20 pour dégager l'écran de l'afficheur, et des poinçonnages 21 et 22 pour laisser passer les sons produits par ces deux composants.

Les deux parties 18 et 18' comprennent en outre des perforations 23, pour la première, et 24, pour la deuxième, qui sont des trous de centrage facilitant la mise en place des parties de feuille protectrice à l'intérieure de la coque 4. Celle-ci est pourvue à cet effet de pions de centrage dont un seul, 25, est visible sur la figure 5, comme on le verra par la suite.

Les deux parties 18 et 18' comprennent enfin l'une et l'autre une patte de mise à la masse, respectivement 26 et 27.

On se tournera maintenant vers la figure 5, qui représente une vue en coupe partielle agrandie de l'appareil des figures 2 et 3, pratiquée selon la ligne B-B' de la figure 2, dans laquelle on retrouve la coque 4, la plaque à circuits imprimés 10, l'écouteur 13, le ronfleur 14, le support d'écouteur 15 et la feuille protectrice 16. Cette figure fait apparaître un pion de centrage 25, comme indiqué précédemment, partie intégrante de la coque 4, ainsi qu'une patte de mise à la masse 27, une zone de contact de masse 28 et un poussoir de masse 29, également partie intégrante de la coque 4. Comme on le voit sur la figure 5, le poussoir 29 appuie sur la patte 27 et la dirige vers la zone de contact de masse 28 de façon que la couche conductrice 1 vienne en contact électrique avec la zone de contact de masse de la plaque de circuits imprimés 10, ce qui permet d'évacuer à la masse des courants dus à des décharges électrostatiques éventuelles, protégeant ainsi les composants de l'appareil, c'est-à-dire non seulement ceux qui sont représentés sur les figures (microphone, écouteur, etc.), mais aussi, par l'intermédiaire de la plaque 10, les composants électroniques plus sensibles avec lesquelles ceux-ci sont en relation.

Des dispositions semblables sont utilisées en relation avec l'autre partie 18 de la feuille protectrice 16.

## Revendications

1. Appareil de communication doté d'une protection électrostatique comprenant un corps en matériau isolant consistant en une feuille protectrice (16) incorporée dans l'appareil, entre la coque (4) et les éléments à protéger (10, 11, 12, 13, 14), cette feuille protectrice comprenant une couche conductrice (1) et une couche isolante (3) et étant découpée à la forme appropriée, caractérisé en ce que la couche conductrice (1) est une feuille mince métallique et en ce que la couche isolante (4) est une feuille de mousse en matière plastique assemblée à la feuille mince métallique pour former un corps plat dont l'épaisseur est telle que, le corps étant en place dans l'appareil, sa forme vient s'adapter à la forme d'un espace laissé libre pour le recevoir de manière à ce que la couche conductrice (1) et la couche isolante (3) soient en contact, au moins partiel, avec respectivement la coque de l'appareil et les éléments à protéger.

2. Appareil conforme à la revendication 1, caractérisé en ce que ladite couche conductrice (1) est une feuille mince de métal ou de fibres métalliques.

3. Appareil conforme à la revendication 2, caractérisé en ce que ladite feuille mince de métal ou de fibres métalliques, ou ladite couche isolante, est revêtue d'une couche adhésive (2).

4. Appareil conforme à l'une quelconque des revendications 1 à 3, caractérisé en ce que ladite couche conductrice est pourvue de moyens de connexion à la masse (26, 27, 28, 29).

5. Appareil conforme à la revendication 4, caractérisé en ce que lesdits moyens de connexion consistent en une patte (26, 27) de ladite feuille protectrice et en ce que l'appareil comprend un poussoir (29) pour presser cette patte contre une zone de contact de masse (28).

6. Appareil conforme à l'une quelconque des revendications 1 à 5, caractérisé en ce que ladite matière plastique est le polyuréthane.

## Patentansprüche

1. Kommunikationsgerät mit einem elektrostatischen Schutz, einen Körper aus einem isolierenden Material umfassend, der aus einem Schutzblatt (16) besteht, das in das Gerät zwischen der Schale (4) und den zu schützenden Elementen (10, 11, 12, 13, 14) eingearbeitet ist, wobei das Schutzblatt eine leitende Schicht (1) und eine isolierende Schicht (3) umfasst und in die geeignete Form zugeschnitten ist, dadurch **gekennzeichnet,** dass die leitende Schicht (1) eine dünnes Metallblatt ist und dass die isolierende Schicht (3) ein Blatt aus Kunststoff-Schaum ist, das an das dünne Metallblatt angefügt ist, um einen flachen Körper zu bilden, dessen Dicke so ist, dass, wenn der Körper in dem Gerät angeordnet ist, seine Form sich an die Form eines Raumes anpasst, der freigelassen ist, um ihn aufzunehmen, so dass die leitende Schicht (1) und die isolierende Schicht (3) zumindest teilweise mit jeweils der Schale des Gerätes und den zu schützenden Elementen in Kontakt stehen.

2. Gerät nach Anspruch 1, dadurch gekennzeichnet, dass die leitende Schicht (1) ein dünnes Blatt aus Metall oder metallischen Fasern ist.

3. Gerät nach Anspruch 2, dadurch gekennzeichnet, dass das dünne Blatt aus Metall oder metallischen Fasern oder die isolierende Schicht mit einer adhäsiven Schicht (2) beschichtet ist.

4. Gerät nach einem beliebigen der Ansprüche 1 bis 3, dadurch gekennzeichnet, dass die leitende Schicht mit Mitteln zur Verbindung mit Masse (26, 27, 28, 29) versehen ist.

5. Gerät nach Anspruch 4, dadurch gekennzeichnet, dass die Mittel zur Verbindung aus einer Lasche (26, 27) des Schutzblattes bestehen und dass das Gerät einen Schieber (29) umfasst, um die Lasche gegen eine Massekontaktzone (28) zu drücken.

6. Gerät nach einem der Anprüche 1 bis 5, dadurch gekennzeichnet, dass der Kunststoff Polyurethan ist.

## Claims

1. A communications set provided with electrostatic protection comprising a body made of an insulating material, the electrostatic protection consisting in a protective sheet (16) incorporated in the set between the shell (4) and the elements to be protected (10. 11, 12, 13, 14), the protective sheet comprising a conductive layer (1) and an insulating layer (3), and being cut to the appropriate shape, said set being characterized in that the conductive layer (1) is a thin metal sheet and in that the insulating layer (3) is a sheet of foam made of a plastics material that is assembled on the thin metal sheet to form a flat body of thickness such that when the body is installed in the set, its shape is organized to fit the shape of a space left empty to receive it inside the set in such a manner that the conductive layer (1) and the insulating layer (3) are in contact, at least in part. respectively with the shell of the set and with the elements to be protected.

2. A set according to claim 1, characterized in that said conductive layer (1) is a thin sheet of metal or of metal fibers.

3. A set according to claim 2, characterized in that said thin sheet of metal or of metal fibers, or said insulating layer, is covered with an adhesive layer (2).

4. A set according to any one of claims 1 to 3, characterized in that said conductive layer is provided with grounding connector means (26. 27. 28. 29).

5. A set according to claim 4, characterized in that said connector means consist in a tab (26. 27) provided on said protective sheet. and in that the set includes a pusher (29) for pressing the tab against a grounding contact zone (28).

6. A set according to any one of claims 1 to 5, characterized in that said plastics material is polyurethane.
